# EUROPEAN PATENT APPLICATION

(11) **EP 3 761 771 A1**
(43) Date of publication of application: **06.01.2021**
(21) Application number: 19184666.6
(22) Date of filing: 05.07.2019
(51) Int. Cl.: H05K 9/00

(54) **APPARATUS AND SYSTEM FOR ELECTRICAL INTERCONNECTION**

(71) Applicant: Nokia Solutions and Networks Oy, 02610 Espoo (FI)
(72) Inventor: Seitz, Reinhold, 91161 Hilpoltstein (DE); Imtaar, Muhammed Atyab, 90419 Nürnberg (DE); Ruess, Rene, 90491 Nürnberg (DE)
(74) Representative: Swindell & Pearson Limited

(57) **Abstract**

Certain examples of the present invention relate to an apparatus and system for electrical interconnection. Certain examples provide a cable assembly (100) for providing an electrical interconnect, the cable assembly comprising: a first mounting means (101) for mounting the cable assembly to an electromagnetically shielded enclosure (206a); a second mounting means (102) for mounting the cable assembly to an electromagnetically shielded enclosure (206b); a plurality of cables (103) extending between and through the first and second mounting means; and electromagnetic shielding means (105) covering the plurality of cables in the region (II) between the first and second mounting means; wherein the first and second mounting means are galvanically coupled to the electrometric shielding means.

## Description

### TECHNOLOGICAL FIELD

Examples of the present disclosure relate to an apparatus and system for electrical interconnection. Some examples, though without prejudice to the foregoing, relate to a cable assembly for electrically interconnecting a first module of a first electromagnetically shielded enclosure with a second module of a second electromagnetically shielded enclosure. In certain particular examples, though without prejudice to the foregoing, a cable assembly is provided for interconnecting a switch card of an Electromagnetic interference (EMI) or radio-frequency interference (RFI) shielded enclosure, such as an Electromagnetic compatibility (EMC) enclosure, with a switch card of a second EMC enclosure, wherein the switch cards are located on a differing shelf/sub-rack, thereby providing an intra-rack interconnect (i.e. an inter-sub-rack interconnect or inter-shelf interconnect).

### BACKGROUND

Conventional apparatus and systems for interconnecting rack-mounted equipment on differing sub-racks/shelves are not always optimal, particularly where high-speed/high-capacity interconnection (for example of the order of 10 Gbps and above) is required.
Whilst an optical interconnection system, i.e. interconnecting one rack mounted electronic equipment module (such as a card, e.g. switch card) located one shelf/sub rack of a server/network/telecommunication rack cabinet with another rack mounted electronic equipment module located on another shelf/sub rack is possible, it can be problematic not least with respect to thermal management, reliability and power consumption. Also, such systems can be expensive. Conventional electrical interconnection systems may also be possible. However, these typically require a lot of space, e.g. not least on the faceplate of the rack-mounted electronic equipment module. Conventionally, an electrical interconnect is affected via one or more cables, having its own connector, which is connected to a connector on the faceplate. For high-speed/high-capacity interconnection, a plurality of interconnecting cables is required. However, for conventional cables (such as Twin-Ax cables, which support one differential pair each) and current connectors for the same, there may not be sufficient space on the faceplate for sufficient numbers of connectors on the faceplate to connect with the required number of cables (and connectors for the same) for providing highspeed/high-capacity interconnection. Furthermore, in conventional systems for electrically interconnecting modules in EMC enclosures, the system interconnect (i.e. cables) must leave the EMC enclosures, creating an unwanted EMC opening wherein the system may be susceptible to EMI/ RFI.
It is useful to provide an improved interconnecting apparatus.

The listing or discussion of any prior-published document or any background in this specification should not necessarily be taken as an acknowledgement that the document or background is part of the state of the art or is common general knowledge. One or more aspects/examples of the present disclosure may or may not address one or more of the background issues.

### BRIEF SUMMARY

The scope of protection sought for various embodiments of the invention is set out by the independent claims. Any examples and features described in this specification that do not fall under the scope of the independent claims are to be interpreted as examples useful for understanding various embodiments of the invention.

According to at least some examples of the disclosure there is provided a cable assembly for providing an electrical interconnect, the cable assembly comprising:
a first mounting means for mounting the cable assembly to an electromagnetically shielded enclosure;
a second mounting means for mounting a second part of the cable assembly to an electromagnetically shielded enclosure;
a plurality of cables extending between and through the first and second mounting means; and
electromagnetic shielding means covering the plurality of cables in the region between the first and second mounting means;
wherein the first and second mounting means are galvanically coupled to the electrometric shielding means.

According to at least some examples of the disclosure there is provided a cable assembly for providing an electrical interconnect, the cable assembly comprising:
a first mount for mounting the cable assembly to an electromagnetically shielded enclosure;
a second mount for mounting a second part of the cable assembly to an electromagnetically shielded enclosure;
a plurality of cables extending between and through the first and second mounts; and
electromagnetic shielding covering the plurality of cables in the region between the first and second mounts;
wherein the first and second mounts are galvanically coupled to the electrometric shielding.

According to at least some examples of the disclosure there is provided:
a cable assembly as mentioned above;
a first electromagnetically shielded enclosure; and
a second electromagnetically shielded enclosure.

The following portion of this 'Brief Summary' section describes various features that can be features of any of the examples described in the foregoing portion of the 'Brief Summary' section.

In some but not necessarily all examples, the first mounting means comprises a first collar extending from a first side of the first mounting means.

In some but not necessarily all examples, the electromagnetic shielding means is configured to cover at least a portion of the first collar.

In some but not necessarily all examples, the cable assembly further comprises means for securing the electromagnetic shielding means to the first collar.

In some but not necessarily all examples, the first mounting means comprises a second collar extending from a second side of the first mounting means.

In some but not necessarily all examples, the cable assembly further comprises protective means configured to cover the plurality of cables in the region between the first and second mounting means.

In some but not necessarily all examples, the protective means is configured to cover at least a portion of the second collar.

In some but not necessarily all examples, the cable assembly further comprises means for securing the protective means to the second collar.

In some but not necessarily all examples, the first mounting means is configured for mounting the cable assembly to a faceplate of at least one selected from the group of:
rack mounted equipment;
a module;
a card; and
a switching card.

In some but not necessarily all examples, the cable assembly further comprises a conductive gasket.

In some but not necessarily all examples, the plurality of cables comprises at least one selected from the group of:
a plurality of cables configured for differential signalling; and
a plurality of twin axial cables.

In some but not necessarily all examples, one or more ends of one or more cables of the plurality of cables comprises a connector configured for connection to an interposer connector.

According to various, but not necessarily all, examples of the disclosure there are provided examples as claimed in the appended claims.

### BRIEF DESCRIPTION OF THE DRAWINGS

For a better understanding of various examples of the present disclosure that are useful for understanding the detailed description and certain embodiments of the invention, reference will now be made by way of example only to the accompanying drawings in which:
FIG. 1 schematically illustrates an example apparatus of the subject matter described herein;
FIG. 2 shows a further example apparatus of the subject matter described herein;
FIGs. 3 - 7 show examples of the subject matter described herein;
FIG. 8 shows another example of the subject matter described herein;
FIG. 9 shows another example of the subject matter described herein; and
FIG. 10 shows another example of the subject matter described herein.

The Figures are not necessarily to scale. Certain features and views of the figures can be shown schematically or exaggerated in scale in the interest of clarity and conciseness. For example, the dimensions of some elements in the figures can be exaggerated relative to other elements to aid explication. Similar reference numerals are used in the figures to designate similar features. For clarity, all reference numerals are not necessarily displayed in all figures.

### DETAILED DESCRIPTION

The Figures schematically illustrate a cable assembly (100) for providing an electrical interconnect, the cable assembly comprising:
a first mounting means (101) for mounting the cable assembly to an electromagnetically shielded enclosure (206a);
a second mounting means (102) for mounting the cable assembly to an electromagnetically shielded enclosure (206b);
a plurality of cables (103) extending between and through the first and second mounting means; and
electromagnetic shielding means (105) covering the plurality of cables in the region (II) between the first and second mounting means;
wherein the first and second mounting means are galvanically coupled to the electrometric shielding means.

For the purposes of illustration and not limitation, in various, but not necessarily all, examples the cable assembly provides a flexible electrical interconnect between a first rack mounted module on a first shelf of a first grounded/EMI/RFI/EMC shielded enclosure and a second rack mounted module on a second different shelf of a second grounded/EMI/RFI/EMC shielded enclosure. The first mounting means comprises a first conductive bushing which has a flange/faceplate for mounting to a faceplate/front face side of the first module of the first EMC enclosure. Likewise, the second mounting means comprises a second conductive bushing which has a flange/faceplate for mounting to a faceplate/front face side of the second module of the second EMC enclosure. The plurality of cables of the cable assembly may comprise a plurality of Twin-Ax cables extending between and through the two conductive bushings. The electromagnetic shielding means may comprise a metallic layer, metallic braid or EMC braid that covers/envelops/encloses the section of the plurality of cables in the region between the conductive bushings (it being noted that, in use, such a middle section between the conductive bushings would be external of the EMC enclosures, whereas the two end sections of the plural cables on either side of the middle section would be internal of an EMC enclosure). The first and second conductive bushings are galvanically coupled to the electrometric shielding means thereby, in effect, defining an electromagnetically shielded ("EMC proof") tunnel between the first and second conductive bushings which provides an EMI/RFI/EMC shielded conduit for the plural cables.

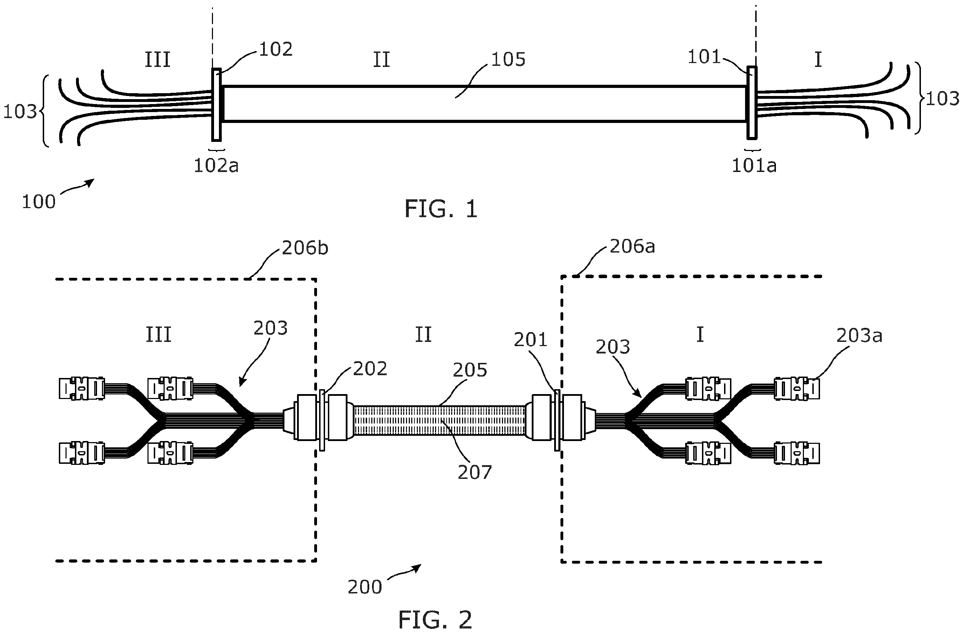

FIG. 1 focuses on the functional components necessary for describing the cable assembly 100. The cable assembly comprises a first mounting means 101 for mounting a first part 101a of the cable assembly to an electromagnetically shielded enclosure (not shown). The cable assembly also comprises a second mounting means 102 for mounting a second part 102a of the cable assembly to another electromagnetically shielded enclosure (not shown). The cable assembly also comprises a plurality of cables 103 extending between and through the first and second mounting means, i.e. such that the cables themselves are not terminated/electrically connected to the mounting means itself, but pass therethrough (and hence in use pass into the electromagnetically shielded enclosure). In some examples the cables are terminated and electrically connected to a module/card internal of the electromagnetically shielded enclosure, such as via on-board interposer connectors on the module/card.
In region II between the first and second mounting means, the plurality of cables are covered by electromagnetic shielding means 105. The first and second mounting means are galvanically coupled to the electrometric shielding means.

As used herein, the term "electrical interconnect" can be used to denote an interconnect for conveying electrical signals such as data/telecommunication signals.
As used herein, the term "mounting means" can used to denote a device configured to effect mounting/attachment. It can, for example, comprise a flange portion defining a mounting plate with apertures therein for receiving fixings, such as mounting screws. The mounting means may also comprise one or more apertures therethrough configured to permit the plurality of cables to pass therethrough and be housed therein - in such a manner such a mounting means may thereby serve as a bushing for the cables (albeit a conductive/metallic bushing that is galvanically connected to the electromagnetic shielding means).
As used herein, the term "electromagnetically shielded enclosure" can be used to denote an enclosure, e.g. of a rack installation system, that has been provided with shielding/screening to protect, e.g. rack mounted equipment therein (such as electrical systems/components, modules, cards, and/or switching cards therein) from Electromagnetic Interference (EMI)/Radio-Frequency Interference (RFI) so as to provide an EMC enclosure.
As used herein, the term "electromagnetic shielding means" can be used to denote means for Electromagnetic Interference (EMI)/Radio-Frequency Interference (RFI) shielding/screening, which attenuates electric fields and electromagnetic energy within EMC applications. The electromagnetic shielding means can, for example, comprise one or more of: a conductive/metallic layer, a conductive/metallic foil, a woven conductive/metallic mesh, a conductive/metallic braid, a conductive/metallic sleeving or an EMC braid such as tubular expandable braided shielding for EMC applications.
As used herein, the term "cable" can used to denote an insulated wire or wires having a protective casing and used for conveying electrical signals such as data/telecommunication signals.

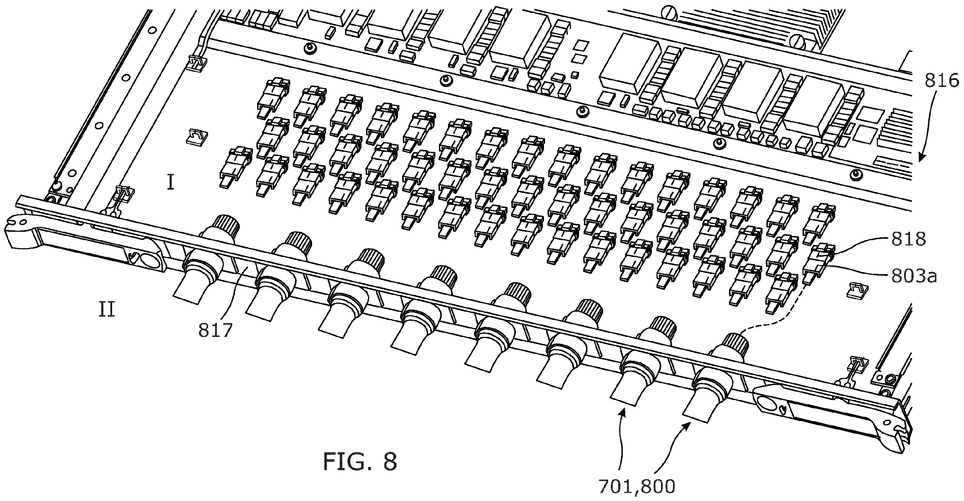

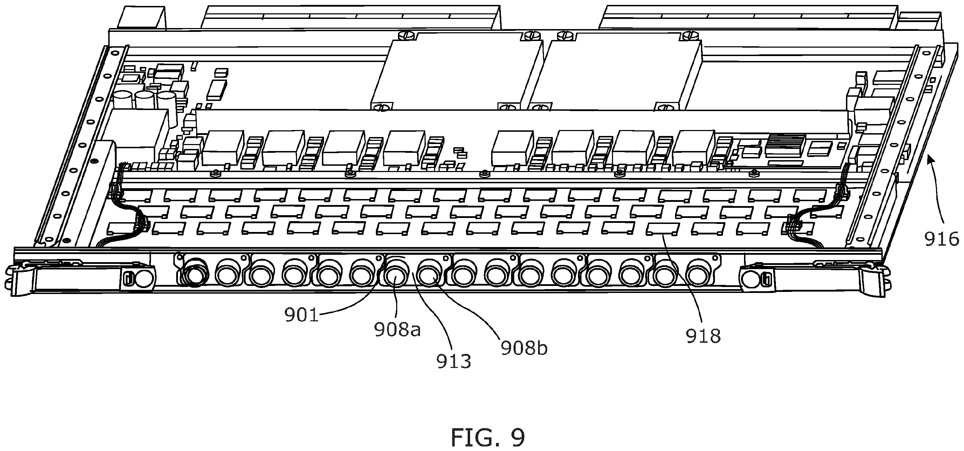

FIG. 2 shows a further example of a cable assembly 200, which comprises: a first mounting means 201 for mounting the cable assembly to a first electromagnetically shielded enclosure 206a. Such mounting of the cable assembly to a first electromagnetically shielded enclosure may comprise mounting one side of the cable assembly to at least one selected from the group of: rack mounted equipment, a module, a faceplate of a rack mounted module, a front side of a rack mounted module, a card, and a switching card.
The cable assembly also comprises a second mounting means 202 for mounting the cable assembly to another electromagnetically shielded enclosure 206b (which may be different to or a part of the same enclosure as the first enclosure 206a). The cable assembly also comprises a plurality of cables 203. Each cable comprising an insulated wire or wires enclosed in a protective casing. The cables of the plurality of cables may comprise at least one selected from the group of: a cable configured for differential signalling, a twin axial cable, a multi-axial cable, or other high-speed/capacity cable. The plurality of cables extends between and through the first and second mounting means. Each cables of the plurality of cables 203 passes straight through and extends beyond the first and second mounting means such that, at each end of the cable assembly, there is a length of the cable (in region I and III respectively) that extends beyond the first and second mounting means (cf. the cable shield/jacket connecting directly to and terminating at the first and second mounting means). Each end of each cable is terminated with a connector 203a, which lies beyond/outside of the first and second mounting means in regions I and III. The connector may be configured for connection to an interposer connector (as illustrated in FIGs 8 and 9) of the module to be interconnected.
In the section of the cable assembly between the first and second mounting means, i.e. the intermediate section of the cable assembly in region II, the plurality of cables are covered by electromagnetic shielding means 205. A protective means 207, configured to provide mechanical protection to the cable assembly, is also provided that covers/envelops/encloses the section of the shielded plurality of cables in region II. Such protective means may comprise: a mechanical protective layer/sleeving/jacket/braid surrounding the shielded plurality of cables whilst still permitting a degree of flexibility of the cable assembly.
The cable assembly can be provided as a module. As used herein 'module' refers to a unit or apparatus that excludes certain parts/components that would be added by an end manufacturer or a user. For example, the end connectors of the plurality of cables of the cable assembly may be separately provided and subsequently attached to the ends of the plurality of cables. When mounting the cable assembly to the faceplate of the module to be interconnected, the connectors on the cable ends can be fed, one after the other, through faceplate apertures/cut-outs and can then be plugged into on-board interposer connectors on the module.

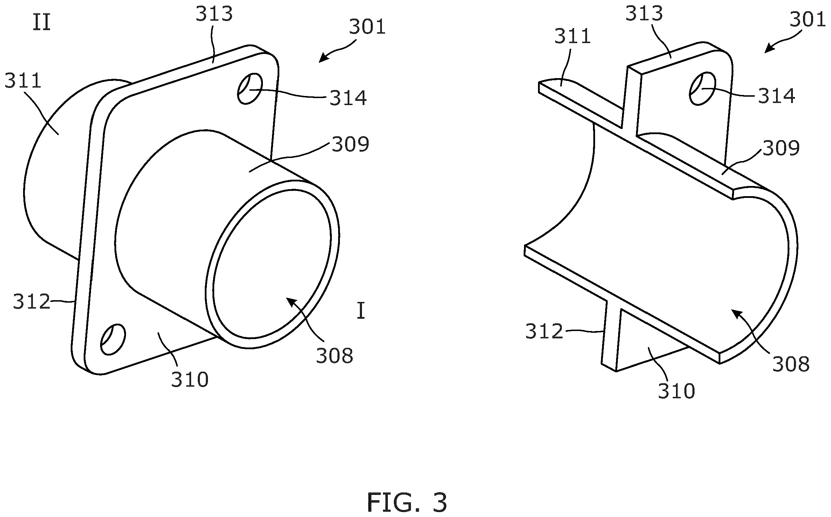

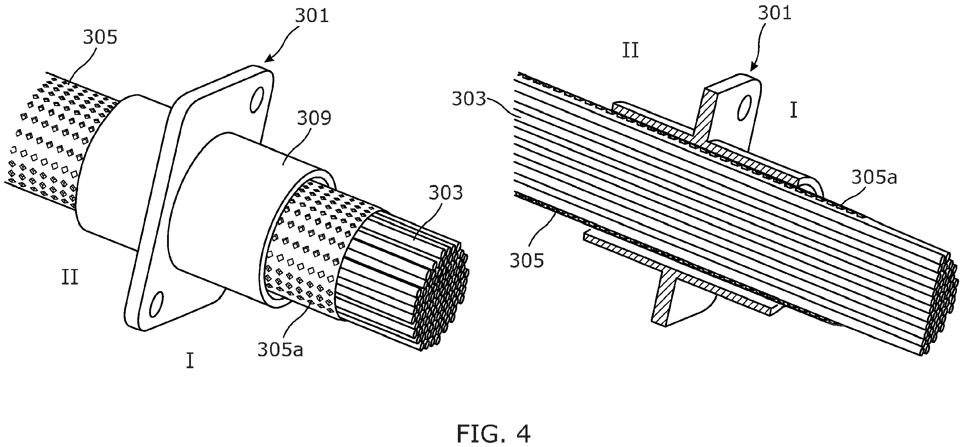

FIG. 3 shows a perspective view of an example of a first mounting means 301 (hereinafter referred to as first "bushing" 301) similar to the mounting means 201 of FIG. 2. FIG. 3 also shows a cross section of the first bushing 301. The first bushing takes the form of a hollow cylindrical tube of a conducting material that defines a central aperture 308 through which a plurality of cables may be inserted (e.g. a cable bundle comprising a laced-up bundle of a plurality of cables as shown in FIG. 4).

The first bushing comprises a flange 313 extending in a radial direction. The flange defines a mounting plate for mounting the first bushing - and hence mounting one side of the cable assembly - to a shielded enclosure or faceplate/front face of a module the same which defines a boundary/outer periphery of the shielded enclosure (e.g. EMC enclosure). The mounting plate comprises one or more apertures 314, or screw holes for receiving fixings, e.g. screws, for mounting the bushing to the shielded enclosure or faceplate of the same. This flange can be optionally sealed with a conductive gasket to the enclosure.
One side of the cylindrical tube, i.e. extending from a first side 310 of the flange portion, defines a first collar 309. The first collar, in effect, forms an extended rim around the aperture that extends in a longitudinal direction from the first side 310. The first collar extends/projects from the first side in an outwardly/distal direction (i.e. away from the midline of the cable assembly). The first bushing and its first collar are configured such that, in use, when the cable assembly is mounted to a first electromagnetically shielded enclosure (e.g. EMC enclosure or cage not shown), at least a distal portion of the first collar passes through an aperture in the shielded enclosure (e.g. an aperture in a faceplate of a switch card within the shielded enclosure, such an aperture being configured to receive and inter-engage with the bushing). The first side 310 thereby defines an "interior facing side", i.e. a side that faces, in use when mounted, an interior of the electromagnetically shielded enclosure to which it is mounted. In use, when mounted, at least a distal part of the first collar extends/projects into an interior of the shielded enclosure. Accordingly, the section of the plurality of cables in region I (which extends through and beyond the first bushing) is likewise, in use, internal of the electromagnetically shielded enclosure. Such an outwardly projecting collar provides a supporting structure to and strain relief to the plurality of cables housed within and passing therethrough, which may avoid/reduce/ameliorate undue strain on the plurality of cables.
The other side of the cylindrical tube, on a second side 312 of the first bushing, defines a second collar 311. The second collar, in effect, forms an extended rim around the aperture that extends in an opposite direction to that of the first collar. The second collar projects/extends from the second side in an inwardly direction, i.e. in a direction towards the midline of the cable assembly. In use when mounted to the shielded enclosure, the second side is external/outside of the shielded enclosure. The second side 312 thereby defines an "exterior facing side", i.e. a side that faces, in use when mounted, an exterior of the shielded enclosure. In use, when mounted, at least a part of the second collar extends/projects to an exterior of the shielded enclosure. Accordingly, the section of the plurality of cables in region II which extend through the first bushing are likewise, in use, external of the electromagnetically shielded enclosure. However, the electromagnetic shielding means ensures that the plural cables are still shielded in spite of being external of the electromagnetically shielded enclosure. The provision of the inwardly projecting second collar provides support and strain relief to the plurality of cables passing therethrough and received therein which may avoid/reduce/ameliorate undue strain on the plurality of cables, avoiding/reducing/ameliorating undue strain on the plurality of cables.

FIG. 4 shows a perspective view and a cross sectional view of the first bushing 301 and a plurality of cables/cable bundle 303) inserted therethrough. In this particular example shown, there are 96 Twin-Ax cables in the plurality of cables/cable bundle - though it is of course to be appreciated that other numbers of cables could be provided e.g. 48. In some examples there may be: >10, >20 > 40, >60, >80 cables in the bundle). Also shown is an electromagnetic shielding means 305 such as an electromagnetic shielding layer or EMC braiding that covers and envelops the cable bundle (it is to be appreciated that the electromagnetic shielding layer would continue to extend [in the leftwards direction] so as to cover the length of the cable bundle up to the second bushing, i.e. so as to cover the length of the cable bundle in region II). Fig. 4 shows that a portion 305a of the electromagnetic shielding means extends past the bushing and its first collar 309. When manufacturing the cable assembly, the electromagnetic shielding layer is provided to overlay and wrap around the cable bundle at least along the length of the cable bundle in region II, i.e. between the first and second bushings. The bushings would be placed over the electromagnetically shielded cable bundle prior to the connector terminations being applied to the ends of the cables of the cable bundle.

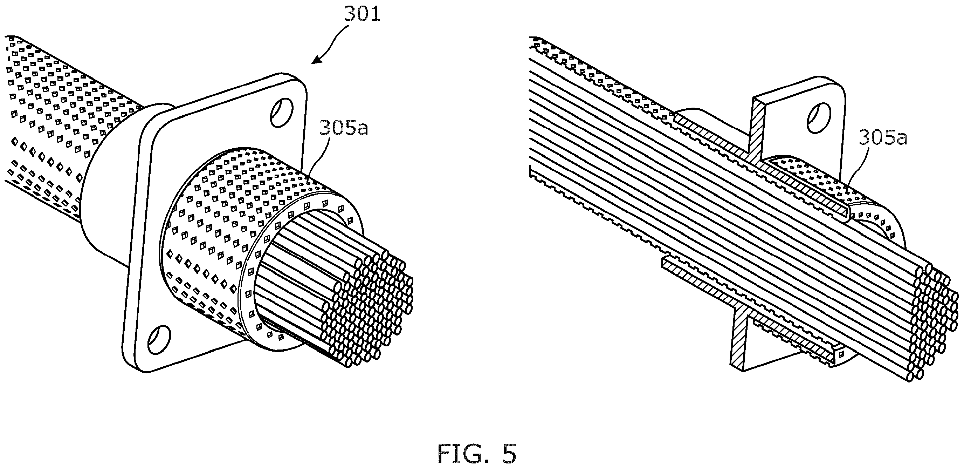

FIG. 5 shows a perspective view of the arrangement of FIG. 4, and a cross sectional view of the same, wherein the portion of the electromagnetic shielding 305a shown in FIG. 4 that extended past the bushing and its first collar 309 has been folded back on itself 305a' to overlay and envelop at least a distal portion of the first collar, such that the electromagnetic shielding covers at least a portion of a surface (in this case an upper surface) of the first collar thereby galvanically coupling and terminating the electromagnetic shielding to the conductive bushing.
The second bushing may be configured in a similar manner to that of the first bushing, mutatis mutandis, thereby providing an intermediate region between the bushings, which in use when mounted to shielded enclosures/face plates of modules/cards to be interconnected, is external of the shielded enclosures. Such an external region of the cable assembly is nevertheless electromagnetically shielded via the electromagnetic shielding means 305 and is terminated at each end via galvanic connection to the conductive bushings (which themselves are connected and grounded to the enclosures/face plates) so as to create/provide an electromagnetically shielded tunnel/conduit for the cable bundle.

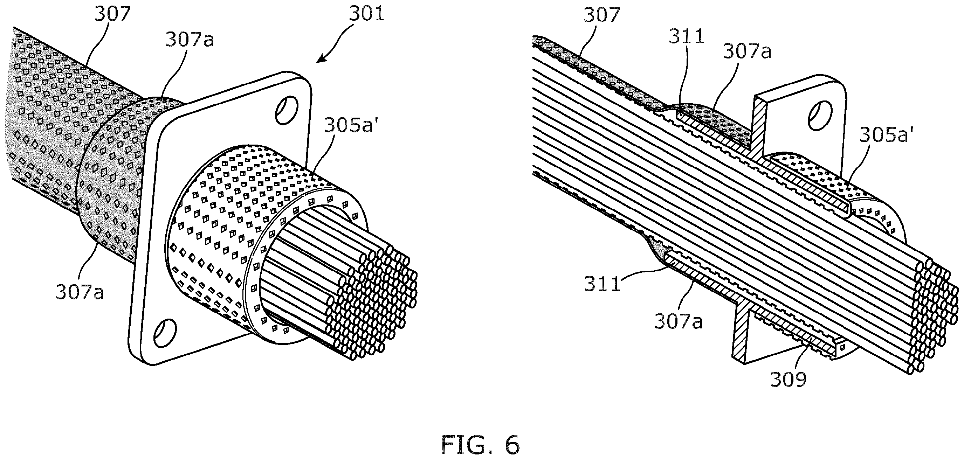

FIG. 6 shows a perspective view of the arrangement of FIG. 5, further comprising protective means 307 that covers the electromagnetically shielded cable bundle. The protective means may be applied so as to cover at least the region II between the two bushings. The protective means 307 also covers at least a distal portion of the second collar 311 such that a distal portion of the protective means 307a covers at least a portion of a surface of the second collar.

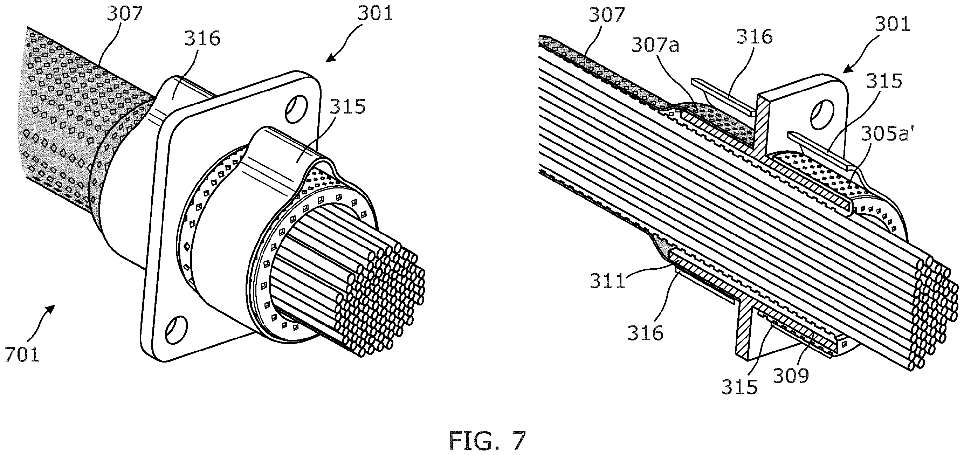

FIG. 7 shows a perspective view of the arrangement of FIG. 6, further comprising first and second fixing means 315 and 316. Such fixing means may comprise: a fastener, a mechanical fastener, a restringing device, a clamp, a clip or a clip ring.
The first fixing means 315 is configured to secure the electromagnetic shielding to the first bushing, e.g. not least to securely attach the folded over distal portion 305a' of the electromagnetic shielding to the first collar 309 of the first bushing 301. The second fixing means 316 is configured to secure the protective means 307 to the first bushing, e.g. not least to securely attach a distal end of the protective means 307a to the second collar of the first bushing.

Figures 3 to 7 show elements of a first bushing. It is to be appreciated that the second bushing may be configured in a similar manner to that of the first bushing, mutatis mutandis (i.e. with the directions of the first and second collars of the second bushing being opposite to the directions of the first and second collars of the first bushing).
A conductive gasket (not shown) may also be provided between the first bushing and the first enclosure to which the cable assembly is attached in order to ensure a reliable/robust galvanic connection around the entirety of the aperture is provided when the cable assembly is mounted to the enclosure. Likewise, a conductive gasket may also be provided between the second bushing and the second enclosure to which the cable assembly is attached.

Figure 8 illustrates a rack mounted module 816, e.g. a switch card, of a shielded enclosure (not shown). The rack mounted module comprises a faceplate 817 which forms a peripheral boundary to the shielded enclosure. The faceplate comprises a plurality of apertures/mounting ports for mounting a plurality of cable assemblies 800 (in particular apertures/mounting ports for mounting a plurality of the bushing arrangements 701 of FIG 7 of the cable assemblies 800). In this particular example, each one of the 8 mounted cable assemblies comprise 96 Twin-Ax cables, such that there are 768 Twin-Ax cables inside the shielded enclosure. The switch card comprises an array of on-board interposer connectors 818. The on-board interposer connectors serve as a 'landing point' for the cables of the cable assembly, i.e. what the terminated connections at the end of each cable of the cable assembly electrically connect to (it is to be appreciated that, for the purposes of clarity and to aid explication, the sections of the cables in region I extending from each bushing 701 to its respective interposer connector are not shown). The interposer connectors (e.g. self-locking interposer connectors) may themselves be connected to components of the modules, e.g. via a fly-over cable design principle.
In this specific example, each of the on-board interposer connectors can support up to 16 Twin-Ax cables. Hence a 16 x 3 array of such interposer connectors is provided to support the 768 Twin-Ax cables. Naturally, it is to be appreciated that other numbers of cables in the plurality of cables of the cable assembly may be provided (e.g. not least 48) and that other arrays and clustering of the interposer connectors may be provided (see 203a of FIG 2).

Figure 9 illustrates another example of a rack mounted module 916, e.g. a switch card having a rack unit height of 1 (1 U), of a shielded enclosure (not shown), for use with cable assemblies according to the present disclosure, wherein the bushings 901 of each cable assembly comprise two laterally spaced apertures 908a and 908b (each aperture with its own inwardly and outwardly projecting collar) in its flange portion/faceplate 913. The two apertures 908a and 908b respectively receive two bundles of cables (not shown), thereby providing a "twin bushing".

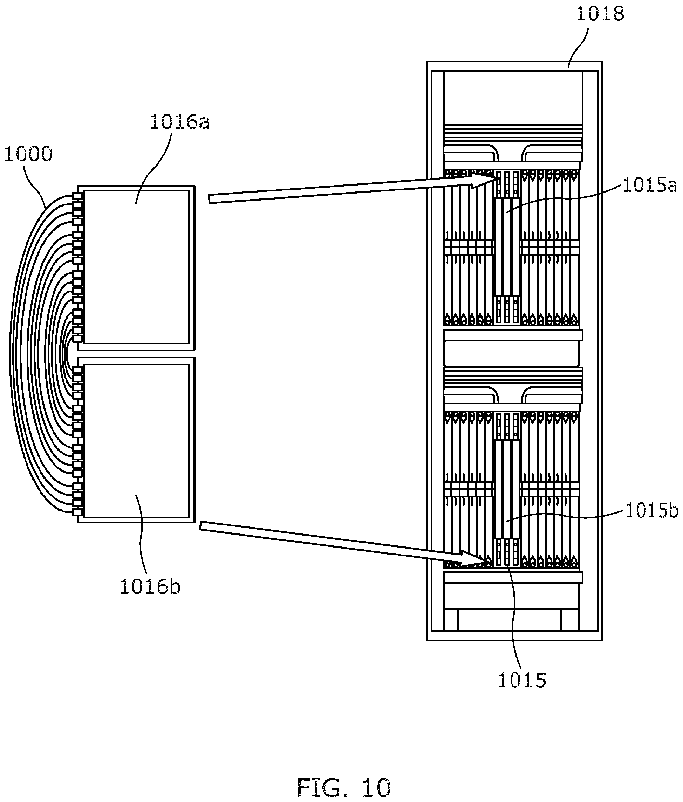

Figure 10 illustrates an example of a system, in this case a rack system 1018 (e.g. of a server, a network or telecommunication cabinet or a data centre) comprising a plurality of racks 1015, split into sub-racks on differing shelves each within an electromagnetically shielded enclosure. The figure schematically shows first and second rack mounted equipment, namely switching cards 1016a and 1016b, respectively installed on sub-racks 1015a, 1015b on differing shelves being electrically interconnected by a plurality of cable assemblies 1000 (it being appreciated that each cable assembly itself comprising a plurality of cables) thereby providing high speed electrical interconnection between the two switching cards.

It should be noted that in the above described examples, certain elements and devices need not be mandatory and thus some can be omitted in certain examples of the present disclosure.
The description of a function should additionally be considered to also disclose any means suitable for performing that function. Where a structural feature has been described, it can be replaced by means for performing one or more of the functions of the structural feature whether that function or those functions are explicitly or implicitly described.
Although specific terms are employed herein, they are used in a generic and descriptive sense only and not for purposes of limitation.
Features described in the preceding description can be used in combinations other than the combinations explicitly described. Although functions have been described with reference to certain features, those functions can be performable by other features whether described or not.
Although features have been described with reference to certain examples, those features can also be present in other examples whether described or not. Accordingly, features described in relation to one example/aspect of the disclosure can include any or all of the features described in relation to another example/aspect of the disclosure, and vice versa, to the extent that they are not mutually inconsistent.
Although various examples of the present disclosure have been described in the preceding paragraphs, it should be appreciated that modifications to the examples given can be made without departing from the scope of the invention as set out in the claims. For example, whilst a bushing with an aperture having a circular cross section is shown, other cross-sectional shapes may be envisaged, not least polygonal or oval.
The term 'comprise' is used in this document with an inclusive not an exclusive meaning. That is any reference to X comprising Y indicates that X can comprise only one Y or can comprise more than one Y. If it is intended to use 'comprise' with an exclusive meaning then it will be made clear in the context by referring to "comprising only one ..." or by using "consisting".
In this description, the wording 'connect', 'couple' and 'communication' and their derivatives mean operationally connected/coupled/in communication. It should be appreciated that any number or combination of intervening components can exist (including no intervening components), i.e. so as to provide direct or indirect connection/coupling/communication. Any such intervening components can include hardware and/or software components.
In this description, reference has been made to various examples. The description of features or functions in relation to an example indicates that those features or functions are present in that example. The use of the term 'example' or 'for example', 'can' or 'may' in the text denotes, whether explicitly stated or not, that such features or functions are present in at least the described example, whether described as an example or not, and that they can be, but are not necessarily, present in some or all other examples. Thus 'example', 'for example', 'can' or 'may' refers to a particular instance in a class of examples. A property of the instance can be a property of only that instance or a property of the class or a property of a sub-class of the class that includes some but not all of the instances in the class.
In this description, references to "a/an/the" [feature, element, component, means ...] are to be interpreted as "at least one" [feature, element, component, means ...] unless explicitly stated otherwise. That is any reference to X comprising a/the Y indicates that X can comprise only one Y or can comprise more than one Y unless the context clearly indicates the contrary. If it is intended to use 'a' or 'the' with an exclusive meaning then it will be made clear in the context. In some circumstances the use of 'at least one' or 'one or more' can be used to emphasise an inclusive meaning but the absence of these terms should not be taken to infer and exclusive meaning.
The presence of a feature (or combination of features) in a claim is a reference to that feature (or combination of features) itself and also to features that achieve substantially the same technical effect (equivalent features). The equivalent features include, for example, features that are variants and achieve substantially the same result in substantially the same way. The equivalent features include, for example, features that perform substantially the same function, in substantially the same way to achieve substantially the same result.
In this description, reference has been made to various examples using adjectives or adjectival phrases to describe characteristics of the examples. Such a description of a characteristic in relation to an example indicates that the characteristic is present in some examples exactly as described and is present in other examples substantially as described.
The above description describes some examples of the present disclosure however those of ordinary skill in the art will be aware of possible alternative structures and features which offer equivalent functionality to the specific examples of such structures and features described herein above and which for the sake of brevity and clarity have been omitted from the above description. Nonetheless, the above description should be read as implicitly including reference to such alternative structures and features which provide equivalent functionality unless such alternative structures or features are explicitly excluded in the above description of the examples of the present disclosure.

Whilst endeavouring in the foregoing specification to draw attention to those features of examples of the present disclosure believed to be of particular importance it should be understood that the applicant claims protection in respect of any patentable feature or combination of features hereinbefore referred to and/or shown in the drawings whether or not particular emphasis has been placed thereon.
The examples of the present disclosure and the accompanying claims can be suitably combined in any manner apparent to one of ordinary skill in the art.
Each and every claim is incorporated as further disclosure into the specification and the claims are embodiment(s) of the present invention. Further, while the claims herein are provided as comprising specific dependencies, it is contemplated that any claims can depend from any other claims and that to the extent that any alternative embodiments can result from combining, integrating, and/or omitting features of the various claims and/or changing dependencies of claims, any such alternative embodiments and their equivalents are also within the scope of the disclosure.

## Claims

1. A cable assembly for providing an electrical interconnect, the cable assembly comprising:
a first mounting means for mounting the cable assembly to an electromagnetically shielded enclosure;
a second mounting means for mounting a second part of the cable assembly to an electromagnetically shielded enclosure;
a plurality of cables extending between and through the first and second mounting means; and
electromagnetic shielding means covering the plurality of cables in the region between the first and second mounting means;
wherein the first and second mounting means are galvanically coupled to the electrometric shielding means.

2. The cable assembly of claim 1, wherein the first mounting means comprises a first collar extending from a first side of the first mounting means.

3. The cable assembly of any previous claim, wherein the electromagnetic shielding means is configured to cover at least a portion of the first collar.

4. The cable assembly of any previous claim, further comprising means for securing the electromagnetic shielding means to the first collar.

5. The cable assembly of any previous claim, wherein the first mounting means comprises a second collar extending from a second side of the first mounting means.

6. The cable assembly of any previous claim, further comprising protective means configured to cover the plurality of cables in the region between the first and second mounting means.

7. The cable assembly of claim 6 when dependent upon claim 5, wherein the protective means is configured to cover at least a portion of the second collar.

8. The cable assembly of claim 7, further comprising means for securing the protective means to the second collar.

9. The cable assembly of any previous claim, wherein the first mounting means is configured for mounting the cable assembly to a faceplate of at least one selected from the group of:
rack mounted equipment;
a module;
a card; and
a switching card.

10. The cable assembly of any previous claim, further comprising a conductive gasket.

11. The cable assembly of any previous claim, wherein the plurality of cables comprises at least one selected from the group of:
a plurality of cables configured for differential signalling; and
a plurality of twin axial cables.

12. The cable assembly of any previous claim, wherein one or more ends of one or more cables of the plurality of cables comprises a connector configured for connection to an interposer connector.

13. A system comprising:
the cable assembly as claimed in any one of previous claims 1 to 12;
a first electromagnetically shielded enclosure; and
a second electromagnetically shielded enclosure.

14. The system of claim 13 further comprising:
a first rack mounted equipment in the first enclosure, wherein the first rack mounted equipment comprises a first faceplate having at least a first aperture therethrough for receiving and mounting the first mounting means; and
a second rack mounted equipment in the second enclosure, wherein the second rack mounted equipment comprises a second faceplate having at least a second aperture therethrough for receiving and mounting the second mounting means.

15. The system of claim 14, wherein:
the first rack mounted equipment comprises a plurality of interposer connectors; and
wherein connectors at one end of the plurality of cables of the cable assembly are configured for connection to the plurality of interposer connectors.
